# EUROPEAN PATENT APPLICATION

(11) **EP 1 465 258 A1**
(43) Date of publication of application: **06.10.2004**
(21) Application number: 03251077.8
(22) Date of filing: 21.02.2003
(51) Int. Cl.: H01L 27/146

(54) **CMOS image sensors**

(71) Applicant: STMicroelectronics Limited, Marlow, Buckinghamshire SL7 1YL (GB)
(72) Inventor: Grant, Lindsay, Edinburgh EH4 3HH (GB)
(74) Representative: Jones, Keith William

(57) **Abstract**

A CMOS image sensor 1 and method of making such sensor uses a coating 11 over the photosensing parts which performs a dual function. In fabrication the coating prevents the formation of silicide, which is not optically opaque, on the photosensing parts. In-use the coating helps to couple light on to the photosensing parts and therefore acts as an anti-reflective layer. The method of fabrication uses a self-aligning technique, which ensures pixel to pixel uniformity.

## Description

The invention relates to semiconductor image sensors, and in particular to such sensors commonly termed CMOS image sensors.

CMOS image sensors typically comprises a matrix of pixels each containing a photosensing part, such as a photodiode, and other active or passive parts. CMOS image sensors are made with the same standard CMOS fabrication processes used in mainstream high-volume wafer fabrication plants to produce IC devices, such as micro-processors, micro controllers and DSPs. This means that signal processing and control circuits may be integrated on the same semiconductor material as the photosensing and other parts, thereby providing a low cost integrated imaging device. Also, CMOS image sensors can benefit from the advances made in the mainstream semiconductor industry.

Increasingly, in what is called a salicide-type process, silicide is applied to IC devices as part of a CMOS fabrication process. The formed silicide has the effect of reducing parasitic resistance and improving switching speed. However, refractory metal silicide suppresses transmission of light and is therefore unsuitable for application to devices including photosensing parts.

US 6,160,282 discloses a CMOS image sensor pixel where the photosensing parts have been protected by silicon oxide from the formation of silicide. The sensor thereby gains from the improvements associated with silicide formation on some non-photosensing parts.

US 5,903,021 discloses how the performance of a CMOS image sensor pixel may be improved by partially "pinning" the photo-diode. Pinning involves covering part of the surface of the photo-diode with a layer of semiconductor material of the same type as the substrate. As a consequence, the potential of the surface is pinned to the potential of the substrate. This increases the quantum efficiency of the photo-diode in addition to reducing its dark current and improving its blue colour response, which is normally the weakest of all the colour responses. As a result, the pixel performs to a high standard.

It has been shown by I. Murakami et al in an article entitled "Technologies to Improve Photo-Sensitivity and Reduce VOD Shutter Voltage for CCD Image Sensors" (IEEE Trans. Electron Devices, vol. 47, 2000, pp. 1566-1572), that quantum efficiency of a photodiode in an image sensor can be improved by applying an anti-reflective coating to increase light coupling.

Photo response uniformity is an important parameter for image sensors. This parameter can be limited by the uniformity of the photo-diode capacitance from pixel to pixel within the sensor matrix. Variation of the patterning of the implants within the pixel can also cause a reduction in the matching of photo response between pixels. One technique used to improve this matching is a self-aligning technique where a single master layer is used to define the implant areas. Each of the different implant areas may then be selected by use of a lower tolerance select mask while maintaining the good matching achieved by use of a single master layer.

According to one aspect, the invention provides a semiconductor image sensor comprising at least one pixel having a photosensing part, characterised in that the photosensing part has a coating which performs a dual function.

Preferably, at least one of the functions of the dual function is a fabrication function. Further preferably, the fabrication function is the prevention of silicide formation

Alternatively or additionally preferably, at least one of the functions of the dual function is an in-use function. Further preferably, the in-use function is anti-reflection.

The constituents and thickness of the coating may be optimised for maximum response at a particular wavelength.

Preferably, the photosensing part comprises a photo-diode. Further preferably, the photodiode is a pinned photodiode. Additionally preferably, the pinned photodiode is partially pinned.

According to another aspect, the invention provides a method of making a semiconductor image sensor comprising forming at least one pixel having a photosensing part, characterised by coating the photosensing part with a coating which performs a dual function.

The invention will now be described, by way of example, with reference to the figures of the drawings in which:
Fig.1 is a cross sectional side view of a pixel in an image sensor according to an aspect of the invention.
Fig. 2(a) is a cross sectional side view of a pixel in an image sensor with implant areas and silicon oxide islands formed and a silicon dioxide layer and a silicon nitride layer.
Fig. 2(b) is a cross sectional side view of a pixel in an image sensor as described in Fig.2(a) with a layer of photoresist applied.
Fig. 2(c) is a cross sectional side view of a pixel in an image sensor as described in Fig.2(b) after exposure to a suitable light source.
Fig. 2(d) is a cross sectional side view of a pixel in an image sensor as described in Fig.2(c) after removal of the unexposed photoresist.
Fig. 2(e) is a cross sectional side view of a pixel in an image sensor as described in Fig.2(d) after removal of the silicon nitride layer and silicon dioxide layer not below the exposed photoresist.
Fig. 3(a) is a cross sectional side view of a pixel in an image sensor with a coating over the photosensitive area formed.
Fig. 3(b) is a cross sectional side view of a pixel in an image sensor as described in Fig.3(a) with a layer of titanium deposited.
Fig. 3(c) is a cross sectional side view of a pixel in an image sensor as described in Fig.3(b) with a layer of silicide formed everywhere except over the photosensitive area.

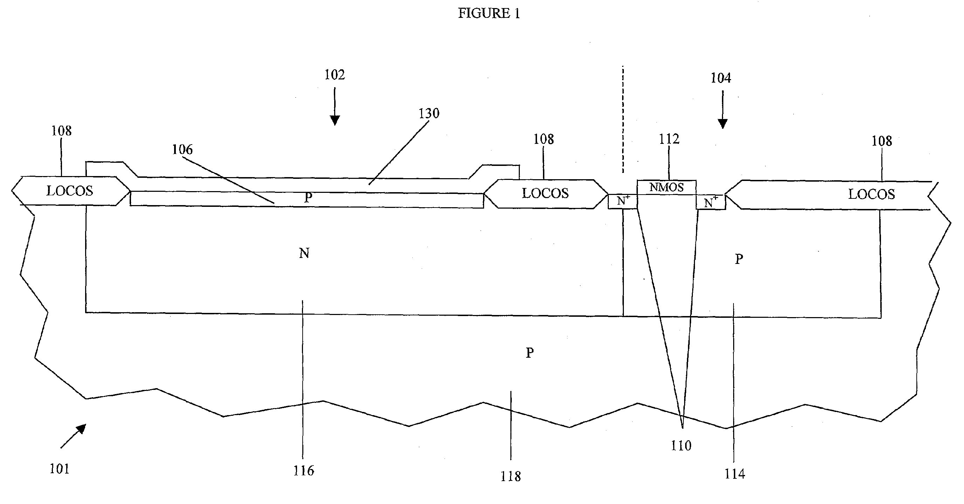

With reference to Fig.1, a pixel indicated generally at 101 is formed on a p-type substrate 118 with a photosensing part 102 and an active part 104. The photosensing part 102 comprises a partially pinned photo-diode formed from an n-well 116 within the substrate 118 and a p-type pinning layer 106 partially covering the n-type well 116. The active part 104 comprises an NMOS transistor formed from two spaced apart, highly doped n-type implants 110 in a p-type well 114. The n-type well 116 is positioned so as to connect the photo sensing and active regions 102, 104. The p-type pinning layer 106 has an anti-reflection coating 130 of silicon nitride on silicon dioxide. In use of the pixel 101, this increases light coupling so as to improve the photo-diode quantum efficiency. During fabrication of the pixel 101, which involves the use of a salicide-type process, the anti-reflection coating 130 prevents the formation of salicide over the photo-diode. Thus, the coating 130 has a dual function.

With reference to figure 1, a pixel 101 is fabricated, prior to the creation of the implant regions 106 and 110 and application of the coating 130, using the well known self-alignment technique. This technique involves creating lands 108 of silicon oxide between parts of the pixel 101. The lands 108 are formed on the surface of the pixel 101 by a stepwise process involving photolithography, using a single master mask layer. The end result of this process is that the surface of the pixel 101 is blocked by silicon nitride everywhere apart from the areas where the lands 108 are to be formed. The pixel 101 is then heated in an oxygen atmosphere such that silicon oxide is formed in the unblocked regions. The silicon nitride blocking is subsequently removed, leaving the silicon oxide lands 108.

The creation of the lands 108 at this stage in the process allows the use of the edges of the lands 108 as reference axes. When each pixel 101 is created the width of the central land 108, in particular, is kept constant, through use of the same master mask layer. This ensures accurate spacing between the N⁺ region 110 of the active part 104, which is connected to the photosensitive part 102, and the pinning part 106. Ensuring the accurate spacing between these parts is critical for pixel to pixel uniformity.

Two separate masks (not shown) are used for the creation of the implant parts 106, 110. Each of these masks covers the entire pixel surface except the specific implant part 106, 110. The width of the central land 108 allows for some error in placement of the appropriate mask on the pixel without compromising the uniformity between pixels.

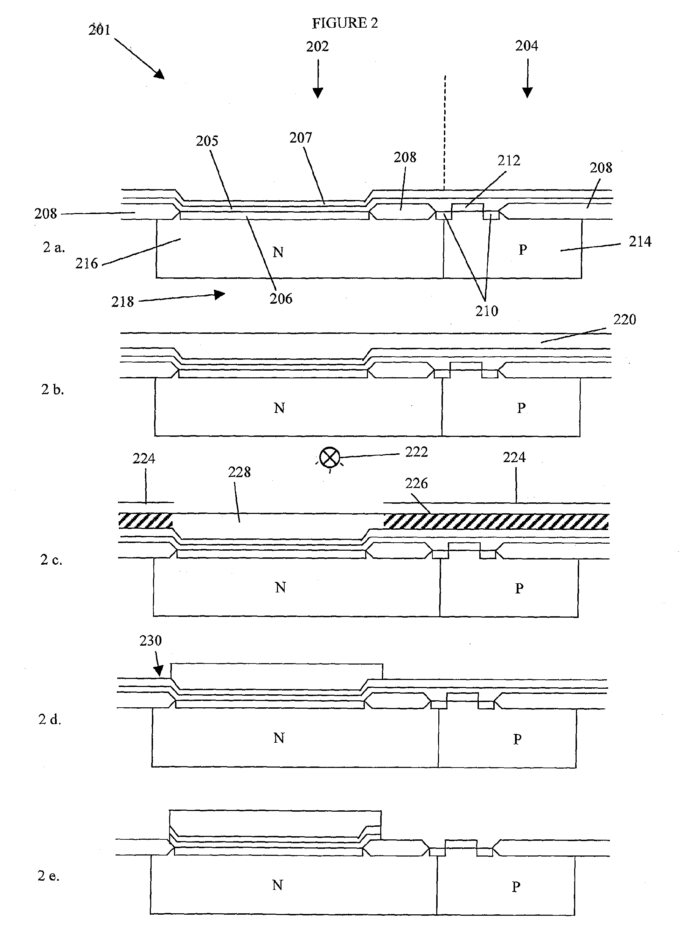

The coating 130, as shown in figure 1, is formed in a stepwise process as shown in figure 2. Figure 2a shows a pixel 201 after the first step of the process, wherein a thin silicon dioxide layer 205 is formed over the exposed silicon. This silicon dioxide layer 205 may be formed by a number of different standard methods including thermal oxidation or chemical vapour deposition. On top of the silicon dioxide layer 205, a silicon nitride layer 207 is formed. Formation of the silicon nitride layer 207 is made by use of a chemical vapour deposition (CVD) process. This may be either thermal or plasma enhanced CVD. The silicon dioxide layer 205 and the silicon nitride layer 207 together form a coating 230.

The thickness of the coating 230, over the photosensitive part 202, is controlled by the length of time of the CVD deposition to give an optimum thickness of 300Å (±50 Å) of the silicon nitride layer 207 and 250Å (±50 Å) of the silicon dioxide layer 205. However, because the coating has a dual function, the thickness of the coating 230 chosen is a balance between being thick enough to prevent silicide formation and being the correct optical path length to ensure an anti-reflective surface in the desired wavelength range. The peak transmission through the coating 230 is normally set to be a maximum at a wavelength of 450nm. This acts to increase the quantum efficiency of the sensor to blue light thereby improving colour camera performance.

A layer of photoresist 220 is then applied to the whole surface of the pixel 201 (figure 2b). A mask 224 is then placed over the pixel 201 such that the photosensitive part 202 is not covered (figure 2c). The pixel 201 is then illuminated through the mask 224 so as to expose the uncovered photoresist 228. The light source 222 and the mask 224 are then removed as well as the unexposed photoresist 226. An etching step is used to remove the coating 230 from the surface of the pixel 201, everywhere apart from over the photosensitive part 202, which is protected from the etching step by the exposed photoresist 228. The photoresist 228 is then removed using a standard photoresist strip process, leaving a pixel 101 as shown in Figure 1.

The salicide type process involves forming silicide on the surface of the pixel. The silicide has the effect of reducing parasitic resistances and therefore is desirable. However, silicide hampers light transmission and so is unsuitable for application to a photosensing part.

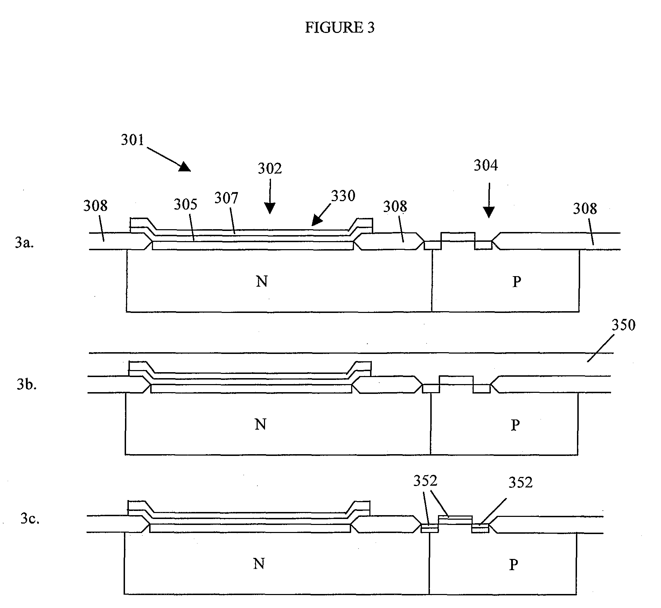

With reference to Figure 3a, a pixel 301 is shown which has gone through the stepwise process required to provide the coating 330. A titanium layer 350 is deposited over the entire surface of the pixel 301 as shown in Figure 3b. In a thermal treatment the titanium reacts with exposed silicon to form silicide 352 but does not react with the silicon nitride layer 307 or silicon dioxide layer 308. Unreacted Titanium deposited on the silicon nitride coating and silicon dioxide may be removed in a wet processing step, as shown in Figure 3c, leaving the coating to come in use as an anti-reflective layer.

## Claims

1. A semiconductor image sensor comprising at least one pixel having a photosensing part, **characterised in that** the photosensing part has a coating which performs a dual function.

2. A sensor as claimed in Claim 1, wherein at least one of the functions of the dual function is a fabrication function.

3. A sensor as claimed in Claim 2, wherein the fabrication function is preventing silicide formation

4. A sensor as claimed in any of Claims 1 to 3, wherein at least one of the functions of the dual function is an in-use function.

5. A sensor as claimed in Claim 4, wherein the in-use function is anti-reflection.

6. A sensor as claimed in any preceding Claim, wherein the photosensing part is a photo-diode.

7. A sensor as claimed in Claim 6, wherein the photo-diode is pinned.

8. A sensor as claimed in Claim 7, wherein the photo-diode is partially pinned.

9. A method of making a semiconductor image sensor comprising at least one pixel having a photosensing part, **characterised by** coating the photosensing part with a coating which performs a dual function.

10. A method as claimed in Claim 9, wherein at least one of the functions of the dual function is a method of fabrication function.

11. A method as claimed in Claim 10, wherein the method of fabrication function is to prevent silicide formation

12. A method as claimed in any of Claims 9 to 11, wherein at least one of the functions of the dual function is an in-use function.

13. A method as claimed in Claim 12, wherein the in-use function is anti-reflection.

14. A method as claimed in any of Claims 9 to 13, further **characterised by** involving a self-aligning technique.

15. A method as claimed in Claim 14, wherein the photosensing part is a photo-diode and further **characterised by** pinning the photo-diode.

16. A method as claimed in Claim 15, wherein the photosensing part is a photo-diode and further **characterised by** partially pinning the photo-diode.
